(19) Europäisches Patentamt
European Patent Office
Office européen des brevets

(11) **EP 1 661 244 B1**

(12) **EUROPÄISCHE PATENTSCHRIFT**

(45) Veröffentlichungstag und Bekanntmachung des Hinweises auf die Patenterteilung:
**10.04.2013 Patentblatt 2013/15**

(21) Anmeldenummer: **04740732.5**

(22) Anmeldetag: **07.07.2004**

(51) Int Cl.:
*H02J 5/00* (2006.01)    *H03H 7/38* (2006.01)

(86) Internationale Anmeldenummer:
**PCT/EP2004/007416**

(87) Internationale Veröffentlichungsnummer:
**WO 2005/029699 (31.03.2005 Gazette 2005/13)**

(54) **VORRICHTUNG ZUR BERÜHRUNGSLOSEN ENERGIEÜBERTRAGUNG**

DEVICE FOR CONTACTLESSLY TRANSMITTING POWER

DISPOSITIF DE TRANSMISSION D'ENERGIE SANS CONTACT

(84) Benannte Vertragsstaaten:
**AT BE BG CH CY CZ DE DK EE ES FI FR GB GR HU IE IT LI LU MC NL PL PT RO SE SI SK TR**

(30) Priorität: **25.08.2003 DE 10339340**

(43) Veröffentlichungstag der Anmeldung:
**31.05.2006 Patentblatt 2006/22**

(73) Patentinhaber: **SEW-EURODRIVE GmbH & Co. KG
76646 Bruchsal (DE)**

(72) Erfinder: **WOLF, Harald
76698 Ubstadt-Weiher (DE)**

(56) Entgegenhaltungen:
**DE-A- 10 053 373     US-B1- 6 252 386**

- **PATENT ABSTRACTS OF JAPAN vol. 1997, no. 03, 31. März 1997 (1997-03-31) -& JP 08 308150 A (TSUBAKIMOTO CHAIN CO; IRIE JUICHI), 22. November 1996 (1996-11-22)**
- **PATENT ABSTRACTS OF JAPAN vol. 1997, no. 03, 31. März 1997 (1997-03-31) & JP 08 308151 A (TSUBAKIMOTO CHAIN CO; IRIE JUICHI), 22. November 1996 (1996-11-22)**

EP 1 661 244 B1

**Beschreibung**

Die Erfindung betrifft eine Vorrichtung zur berührungslosen Energieübertragung.

Aus der DE 100 53 373 A1 ist eine Vorrichtung und ein Verfahren zur berührungslosen Energieübertragung bekannt. Dabei ist eine Einspeisung mit einem Anpasssteller verbunden, wobei der Anpasssteller einen aktiv anzusteuernden Schalter 25 und die zugehörige Ansteuerelektronik mit Regelelektronik aufweist. Somit ist der Anpasssteller aufwendig und kostspielig. Darüber hinaus weist der Schalter abhängig von zu schaltenden Spannungen, Strömen und Anzahl von Schaltvorgängen sowie Temperatur eine geringe Lebensdauer auf. Sogar bei Nicht-Belastung treten prinzipbedingt Halbleiterverluste auf, wenn kein spezielles Kurzschlussrelais eingesetzt wird. Die Verlustwärmeproduktion ist hoch, weshalb ein Kühlkörper vorgesehen werden muss, der zu einer höheren Masse des beweglichen Teiles der Vorrichtung führt.

Ein weiterer Nachteil der DE 100 53 373 A1 ist, dass ein langsames Hochfahren bei Einschalten der Anlage nur erschwert ausführbar ist. Denn ein langsames Hochfahren des primären Linienleiterstromes begrenzt nicht die auftretende Spitzenleistung zum Laden der Zwischenkreiskondensatoren von als Verbrauchern angeschlossenen Umrichtern. Zur Begrenzung ist dort eine spezielle Maßnahme in der Regelung des Anpassstellärs notwendig, die eine Sollwertrampe für die Ausgangsspannung generiert.

Aus der JP 08-308150 A ist eine Vorrichtung zur berührungslosen Energieübertragung elektrischer Leistung aus einer oder mehreren Mittelfrequenzstromquellen bekannt, wobei eine nachgeschaltete Anpassschaltung zum Bereitstellen einer eingeprägten Mittelfrequenz-Spannung für den Verbraucher vorgesehen ist, wobei eine Übertragungsstrecke von einer Mittelfrequenzstromquelle mit einem eingeprägten Mittelfrequenzstrom gespeist wird, wobei die Anpassschaltung als stromgesteuerte Spannungsquelle ausgeführt ist

Aus der US 6 252 386 B1 ist eine Anordnung zur berührungslosen Energieübertragung bekannt, bei der die Sekundärwicklung in mehreren Teilwicklungen ausgeführt ist, zwischen welche jeweilige Kapazitäten in Reihe angeordnet sind.

Aus der DE 100 53 373 A ist eine Anordnung zur berührungslosen Energieübertragung bekannt, bei der mehrere Sekundärwicklungen vorgesehen sind, deren Ausgangsstrom einem jeweiligen Gleichrichter zugeführt wird, deren Ausgangsströme zusammengeführt werden an einen Anpasssteller.

Aus der JP 08-308151 eine Anordnung zur berührungslosen Energieübertragung bekannt, bei der der sekundärseitige Strom über eine Induktivität geleitet wird und dann an die zu versorgende Last weitergeleitet wird.

Der Erfindung liegt daher die Aufgabe zugrunde, eine Vorrichtung zur berührungslosen Energieübertragung weiterzubilden unter Vermeidung der vorgenannten Nachteile. Insbesondere soll die Vorrichtung zur berührungslosen Energieübertragung eine längere Lebensdauer aufweisen und insgesamt robuster sein, insbesondere auch gegen mechanische Belastungen.

Erfindungsgemäß wird die Aufgabe bei der Vorrichtung zur berührungslosen Energieübertragung nach den in Anspruch 1 angegebenen Merkmalen gelöst.

Wesentliche Merkmale der Erfindung bei der Vorrichtung sind, dass die Vorrichtung ausgeführt ist zur berührungslosen Energieübertragung elektrischer Leistung aus einer oder mehreren Mittelfrequenzstromquellen, deren Frequenzen Abweichungen um die Mittelfrequenz $f_M$ aufweisen können, auf mindestens einen bewegten Verbraucher über eine oder mehrere Übertragungsstrecken und den Verbrauchern zugeordneten Übertragerköpfen

mit nachgeschalteter Anpassschaltung zum Bereitstellen einer eingeprägten Mittelfrequenz-Spannung für den Verbraucher,

wobei eine Übertragungsstrecke von einer Mittelfrequenzstromquelle mit einem eingeprägten Mittelfrequenzstrom gespeist wird,

wobei die Anpassschaltung als stromgesteuerte Spannungsquelle ausgeführt ist.

Von Vorteil ist dabei, dass die Vorrichtung einfach und robust mit wenig Aufwand ausführbar ist. Außerdem ist sie kostengünstig herstellbar, weil sie mit wenigen Bauelementen realisierbar ist. Ein Halbleiterschalter ist nicht notwendig für den Anpasssteller, da die Erfindung mit passiven Bauelementen, wie Spulen und Kondensatoren realisierbar ist. Die Wärmeproduktion der Vorrichtung ist gering. Darüber hinaus ist ein langsames Hochfahren bei Einschalten der Anlage ausführbar. Denn ein langsames Hochfahren des primären Linienleiterstromes führt zu einer langsamen Zunahme der Ausgangsspannung der Anpassschaltung. Dies ist ein besonders wesentlicher Vorteil bei als Verbraucher angeschlossenen Umrichtern mit Gleichrichter und Gleichspannungszwischenkreis, weil dann die auftretende Spitzenleistung zum Laden der Zwischenkreiskondensatoren gering gehalten wird. Bei Anschluss eines Umrichters als Verbraucher anstelle eines ohmschen Verbrauchers wird die gleichgerichtete Ausgangsspannung des Vierpols als Zwischenkreisspannung des Umrichters verwendbar.

Wesentlich ist bei der Vorrichtung auch, dass der Verbraucher mit eingeprägter Spannung versorgbar ist anstatt mit eingeprägtem Strom. Somit sind die meisten in Industrie oder Haushalt gebräuchlichen Verbraucher mit der Vorrichtung versorgbar, insbesondere Umrichter mit Spannungszwischenkreis.

Bei einer vorteilhaften Ausgestaltung ist dem Übertragerkopf sekundärseitig ein Kompensationskondensator parallel geschaltet. Insbesondere bildet die Kapazität des Kompensationskondensators mit der Induktivität $L_K$ der Sekundärseite des Übertragerkopfes einen Schwingkreis, dessen Resonanzfrequenz mit der Mittelfrequenz $f_M$ übereinstimmt oder nicht mehr abweicht als 10%. Der Übertragerkopf ist derart mit einem Kompensationskondensator ausgeführt, dass der Übertragerkopf auf seiner Ausgangsseite sich als eingeprägte Stromquelle verhält und/oder der Übertragerkopf zusammen mit seinem Kompensationskondensator $C_K$ eine Mittelfrequenzstromquelle darstellt, insbesondere mit einem möglichst großem Innenwiderstand. Von Vorteil ist dabei, dass die Stromquelleneigenschaften des Übertragerkopfes möglichst ideal sind.

Als vorteilhafte Wahl zur Dimensionierung hat sich herausgestellt, dass der Kompensationskondensator $C_K$ des Übertragerkopfes und die Induktivität $L_K$ des Übertragerkopfes derart dimensioniert sind, dass

$$f_1 = \frac{1}{2\pi\sqrt{L_K C_K}}$$ von $f_o$ höchstens 5 % abweicht. Besonders vorteilhaft ist Gleichheit.

Bei einer vorteilhaften Ausgestaltung ist die Anpassschaltung als derartiger Vierpol ausgeführt, dass bei ohmschem Verbraucher und konstanter Frequenz eines sinusförmigen Eingangsstroms der Betrag der Ausgangsspannung dem Betrag des Eingangsstroms mit dem Proportionalitätsfaktor Z proportional ist. Von Vorteil ist dabei, dass eine konstante Ausgangsspannung lieferbar ist, weil der Mittelfrequenzstrom in der Übertragungsstrecke konstant haltbar ist mittels einer entsprechenden Regelung. Bei einer vorteilhaften Ausgestaltung umfasst der Vierpol $V_1$ zumindest eine Kapazität $C_{g1}$ und eine Induktivität $L_{g1}$ umfasst, die den Proportionalitätsfaktor Z bestimmen.

Vorteilhaft ist es, den Vierpol derart aufzubauen, dass er zumindest einen inneren Vierpol umfasst, welcher zwischen seinen Eingangsklemmen eine Kapazität $C_{g1}$ aufweist und eine Induktivität $D_{g1}$ zwischen einer ersten Eingangsklemme und einer ersten Ausgangsklemme geschaltet ist und die zweite Ausgangsklemme mit der zweiten Eingangsklemme direkt verbunden ist. Dabei weicht vorteiligerweise die Frequenz f des Eingangsstromes von der Frequenz $f_o = \frac{1}{2\pi\sqrt{L_{g1} C_{g1}}}$

höchstens 10 % ab. Bei Gleichheit liegen Idealbedingungen vor. Somit sind vorteiligerweise die Spannungsquelleneigenschaften des inneren Vierpols möglichst ideal ausgeführt. Der Proportionalitätsfaktor Z ist vorteiligerweise derart gewählt, dass $Z = \sqrt{\dfrac{L_{g1}}{C_{g1}}}$ beträgt. Somit

sind zwar noch Zweipole vor oder nach dem inneren Vierpol einfügbar, jedoch keine weiteren Vierpole mit Induktivitäten und Kapazitäten.

**Erfindungsgemäß** ist zwischen eine erste Eingangsklemme der Anpassschaltung und die erste Eingangsklemme des inneren Vierpols ein erster Zweipol zwischengeschaltet und zwischen die zweite Eingangsklemme der Anpassschaltung und die zweite Eingangsklemme des inneren Vierpols ein zweiter Zweipol zwischengeschaltet und

zwischen die beiden Ausgangsklemmen des inneren Vierpols ein dritter Zweipol geschaltet und

die erste Ausgangsklemme des inneren Vierpols mit der ersten Ausgangsklemme der Anpassschaltung direkt verbunden und

die zweite Ausgangsklemme des inneren Vierpols mit der zweiten Ausgangsklemme der Anpassschaltung direkt verbunden. Von Vorteil ist dabei, dass mittels einem oder mehreren dieser Zweipole die Blindspannung am Ausgang des Übertragerkopfes, also am Eingang der Anpassschaltung, kompensierbar ist. Insbesondere mittels des dritten Zweipols ist die Parameterempfindlichkeit der Ausgangsspannung der Anpassschaltung bezüglich des Kompensationskondensators $C_K$ verringerbar. Dies ist insbesondere dann wichtig, wenn $C_K$ größer oder sehr viel größer als die Kapazität $C_{g1}$ ist.

Bei einer vorteilhaften Ausgestaltung ist der erste und/oder der zweite Zweipol als direkte Verbindung, also Kurzschluss, ausgeführt. Bei einer alternativen vorteilhaften Ausgestaltung ist der dritte Zweipol als Unterbrechung ausgeführt, also nicht vorhanden. Somit sind keine kostspieligen Bauelemente notwendig.

**Erfindungsgemäß** Ausgestaltung gleicht die Summe der Induktivitäten des ersten und des zweiten Zweipols dem Wert der Induktivität $L_{g1}$ des inneren Vierpols und der dritte Zweipol ist eine Unterbrechung. Somit ist mit einfachen Mitteln die Blindleistungsspannung kostengünstig kompensierbar. Darüber hinaus ist die Parameterempfindlichkeit der Ausgangsspannung der Anpassschaltung bezüglich des Kompensationskondensators $C_K$ verringerbar. Dies ist insbesondere dann wichtig, wenn $C_K$ größer oder sehr viel größer als die Kapazität $C_{g1}$ ist.

Bei der alternativen vorteilhaften Ausgestaltung ist insbesondere der erste und zweite Zweipol jeweils als direkte Verbindung ausgeführt und der dritte Zweipol ist ein Kondensator mit der Kapazität $C_{g2}$. Insbesondere stimmt die Kapazität $C_{g2}$ überein mit der Kapazität $C_{g1}$ des inneren Vierpols. Somit ist mit einfachen Mitteln die Blindleistungsspannung kostengünstig kompensierbar. Darüber hinaus ist wiederum die Parameterempfindlichkeit der Ausgangsspannung der Anpassschaltung bezüglich des Kompensationskondensators $C_K$ verringerbar. Dies ist insbesondere dann wichtig, wenn $C_K$ größer oder sehr viel größer als die Kapazität $C_{g1}$ ist.

Bei einer vorteilhaften Ausgestaltung ist am Ausgang der Anpassschaltung ein Gleichrichter zum Erzeugen einer unipolaren Zwischenkreisspannung für einen vom Verbraucher umfassten Umrichter vorgesehen.

Weitere Vorteile ergeben sich aus den Unteransprüchen.

**Bezugszeichenliste**

$C_K$ Kompensationskondensator
$L_K$ Induktivität
$C_{g1}$ Kapazität
$L_{g1}$ Induktivität
$Z$ Proportionalitätsfaktor
$C_{g2}$ Kapazität
$R_L$ Lastwiderstand

Die Erfindung wird nun anhand von Abbildungen näher erläutert:

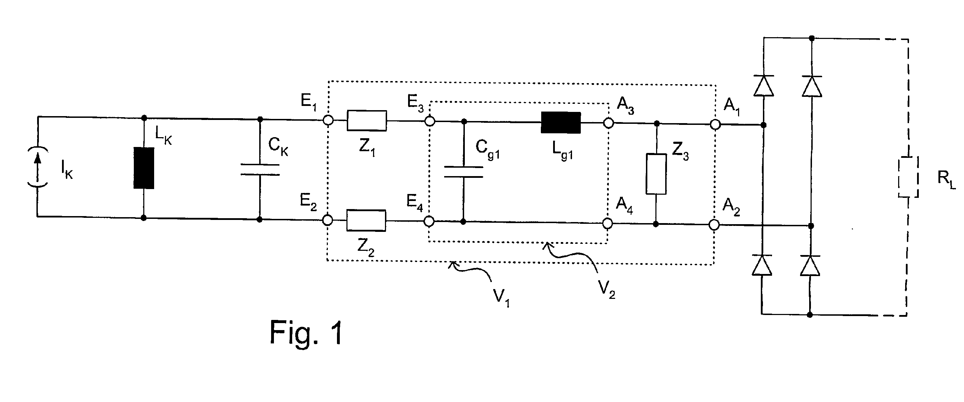

In der Figur 1 ist das elektrische Ersatzschaltbild des beweglichen Teils der erfindungsgemäßen Vorrichtung gezeigt. Der stationäre Teil ist gemäß DE 100 53 373 A1 vorsehbar.

Wie auch in der DE 100 53 373 A1 weist der Übertragerkopf die sekundärseitige Induktivität $L_K$ auf, welche durch den Kompensationskondensator $C_K$ in ihrer Wirkung bei der Mittelfrequenz kompensiert wird. Die Energie wird vom Einspeisesteller ESS über die Strecke an den Übertragerkopf berührungslos übertragen. Der Übertragerkopf zusammen mit dem Kompensationskondensator $C_K$ wirkt als eingeprägte Stromquelle $I_K$, wie in Figur 1 gezeigt.

An den Übertragerkopf ist ein Vierpol $V_1$ mit seinen Eingangsklemmen E1 und E2 angeschlossen, der an seinem Ausgang, also mit den Ausgangsklemmen A1 und A2 mit einem Gleichrichter zur Versorgung eines Umrichters verbunden ist.

Der Vierpol $V_1$ ist derart ausgeführt, dass bei Anlegen einer rein ohmsche Last an den Ausgangsklemmen A1 und A2 und bei konstanter Frequenz eines sinusförmigen Eingangs-Stromes des Vierpols $V_1$ der Betrag der Ausgangsspannung proportional ist zum Betrag des Eingangs-Stromes, insbesondere belastungsunabhängig, wobei der Proportionalitätsfaktor Z ist. Diese Proportionalität gilt sogar auch dann, wenn die Last statt aus einer rein ohmschen aus einer beliebigen linearen komplexen Last besteht, also aus einer beliebigen Schaltung aus Induktivitäten, Kapazitäten und ohmschen Widerständen besteht.

Bei dem erfindungsgemäßen Ausführungsbeispiel nach Figur 1 umfasst der Vierpol $V_1$ einen inneren Vierpol $V_2$, dessen Eingangsklemmen E3 und E4 über Zweipole $Z_1$ und $Z_2$ mit den Eingangsklemmen E1 und E2 des Vierpols $V_1$ verbunden sind. Außerdem liegt zwischen den Ausgangklemmen A3 und A4 ein Zweipol $Z_3$, wobei die Ausgangsklemme A3 mit der Ausgangsklemme A1 des Vierpols $V_1$ und die Ausgangsklemme A4 mit der Ausgangsklemme A2 des Vierpols $V_1$ jeweils direkt verbunden ist.

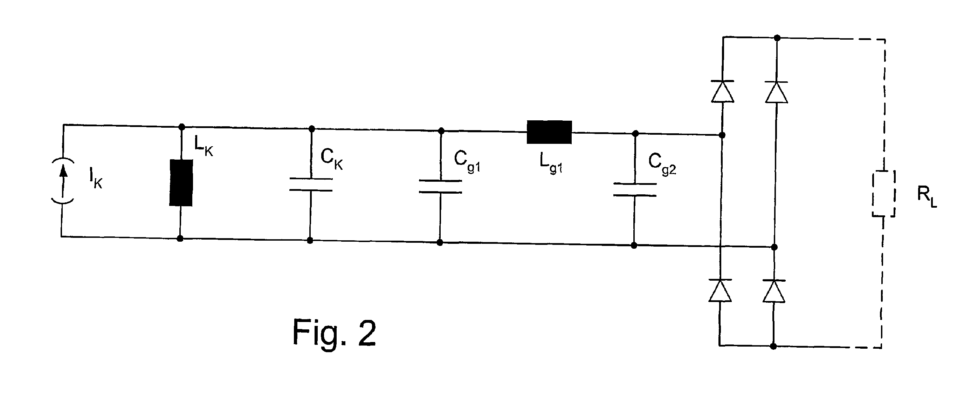

Die Zweipole sind bei verschiedenen erfindungsgemäßen Ausführungsbeispielen verschieden ausführbar. In Figur 2 ist eines der Ausführungsbeispiele gezeigt. Dabei sind die Zweipole $Z_1$ und $Z_2$ als direkte Verbindungen, also Kurzschlüsse, ausgeführt und der Zweipol $Z_3$ als Kondensator mit der Kapazität $C_{g2}$. Mit diesem Kondensator lässt sich die Parameterempfindlichkeit der Ausgangsspannung der Anpassschaltung bezüglich des Kompensationskondensators $C_K$ verringern, insbesondere wenn $C_K$ größer oder sehr viel größer als die Kapazität $C_{g1}$ der Figur 2 ist. Außerdem ist bei diesem Ausführungsbeispiel eine sehr gute Blindspannungskompensation am Eingang der Anpassschaltung erreichbar, insbesondere wenn die Kapazität $C_{g2}$ der Kapazität $C_{g1}$ gleicht.

Dieselben Vorteile erreicht man aber auch bei anderen erfindungsgemäßen Ausführungsbeispiel bei dem der Zweipol $Z_3$ als offene Verbindung ausgeführt ist und die beiden Zweipole $Z_1$ und $Z_2$ als Induktivitäten ausgeführt sind, deren Summe der Induktivität $L_{g1}$ des inneren Vierpols $V_2$ gleicht.

Bei einem erfindungsgemäßen Ausführungsbeispiel bestimmen eine Kapazität $C_{g1}$ und eine Induktivität $L_{g1}$ den Proportionalitätsfaktor Z. Idealerweise sind die Kapazität $C_{g1}$ und die Induktivität $L_{g1}$ derart dimensioniert, dass der Proportionalitätsfaktor $Z = \sqrt{\dfrac{L_{g1}}{C_{g1}}}$ beträgt und die Frequenz f des Eingangsstromes der Frequenz $f_o = \dfrac{1}{2\pi\sqrt{L_{g1}C_{g1}}}$ gleich ist. Abweichungen von einigen Prozent, beispielsweise bis zu 5 %, beeinträchtigen die Vorteile nur in geringem Umfang. Der Kompensationskondensator $C_K$ des Übertragerkopfes und die Induktivität $L_K$ des Übertragerkopfes sind derart dimensioniert, dass $f_1 = \dfrac{1}{2\pi\sqrt{L_K C_K}}$ gleich ist zu $f_o$. Auch hier sind Abweichungen von einigen Prozent, beispielsweise bis zu 5 %, nicht wesentlich verschlechternd.

Auch Abweichungen von bis zu 10 % statt 5 % sind noch akzeptabel bezüglich der Funktion des Übertragerkopfes und der Anpassschaltung.

Die Kapazität $C_{g1}$ bildet zusammen mit der Induktivität $L_{g1}$ eine stromgesteuerte Spannungsquelle bei der Mittelfrequenz $f_M$, also ist der Betrag der Spannung am Ausgang proportional zum Betrag des Linienleiterstrom der Strecke und ist unabhängig von der Belastung.

Wenn die genannten Abweichungen verschwinden, liegt auch bei linearen Lasten, wie Spulen, Widerständen Kondensatoren oder deren beliebige Zusammenschaltungen, keine Belastungsabhängigkeit im genannten Proportionalitätsverhalten vor. Bei zunehmenden Abweichungen tritt eine Abhängigkeit von der Belastung auch bei solchen Lasten zunehmend auf.

Die Kapazität $C_{g2}$ bildet zusammen mit der Induktivität $L_{g1}$ einen Reihenschwingkreis, der bei geringer Belastung, also großem Lastwiderstand $R_L$ einen Kurzschluss darstellt. Bei steigender Belastung wird der Reihenschwingkreis stärker bedämpft. Der Reihenschwingkreis wirkt dann nicht mehr als Kurzschluss. Auf diese Weise stellt sich dann eine automatische Anpassung an die Lastverhältnisse ein. Auf die Eigenschaft als stromgesteuerte Spannungsquelle hat der Kondensator $C_{g2}$ keinen negativen Einfluss, da er einfach parallel zur Last liegt. Im Gegenteil bewirkt der Kondensator $C_{g2}$ sogar, dass eine Verstimmung des Kompensationskondensator $C_K$ nahezu keine Auswirkung auf die Spannungskonstanz der Ausgangsspannung der Anpassschaltung hat.

Die Anpassschaltung ist passiv und mit einer sehr geringen Anzahl von Bauteilen ausgeführt und daher robust und kostengünstig.

Bei weiteren Ausführungsbeispielen ist auch eine Parallelschaltung von mehreren Anpassschaltungen mit angeschlossenen Gleichrichtern ausführbar zur Erhöhung der übertragbaren Leistung.

Bei weiteren erfindungsgemäßen Ausführungsbeispielen ist zur verbesserten Regelung der Ausgangsspannung ein nachgeschalteter Tief/Hochsetzsteller oder eine steuerbare Induktivität $L_{g1}$ einsetzbar. Die genannte Steuerbarkeit der Induktivität ist realisierbar, indem mittels eines zusätzlichen Gleichstromkreises eine lokale Sättigung im magnetischen Kreis der Spule $L_{g1}$ bewirkt wird. Auf diese Weise ist die Ausgangsspannung des Vierpols zu beeinflussen.

Wie in Figur 1 und 2 gezeigt, ist am Ausgang der Anpassschaltung ein Gleichrichter zum Erzeugen einer unipolaren Zwischenkreisspannung für einen vom Verbraucher umfassten Umrichter vorsehbar. Bei einem solchen Verbraucher mit Gleichrichter liegt jedoch die oben genannte Proportionalität nicht ideal vor.

Bei weiteren erfindungsgemäßen Ausführungsbeispielen trägt die Spule mit der Induktivität $L_{g1}$ eine weitere Wicklung zur Erzeugung von Hilfsspannung. Diese Hilfsspannung kann beispielsweise verwendet werden zur Versorgung eines Schaltungsteils, das den Strom zur Steuerung der Induktivität $L_{g1}$ bei der oben genannten steuerbaren Ausführung erzeugt.

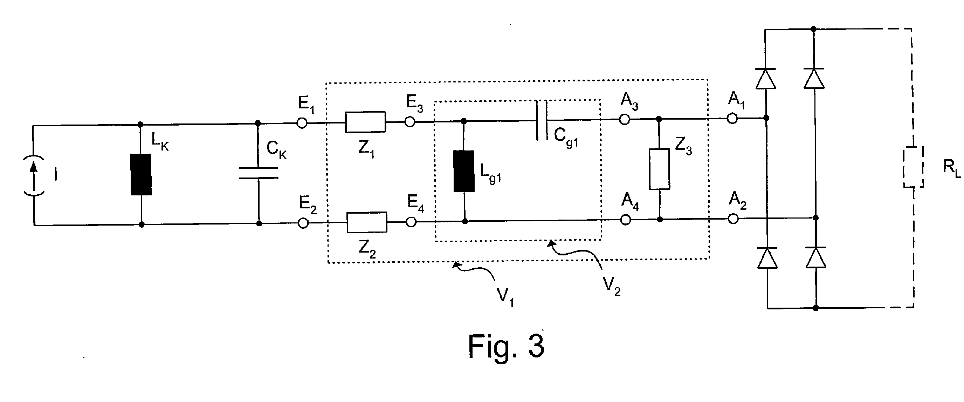

Bei weiteren erfindungsgemäßen Ausführungsbeispielen ist entsprechend der Figur 3 die Anordnung der Kapazität $C_{g1}$ und Induktivität $L_{g1}$ vertauscht.

Die Erfindung umfasst auch alle elektrotechnisch gleichwertigen Schaltungsarten und Anordnungen.

Insbesondere sind bei anderen erfindungsgemäßen Ausführungsbeispielen nach Figur 3 die Zweipole $Z_1$ und $Z_2$ als Kurzschlüsse ausgeführt. In diesem Fall ist es sogar ermöglicht, eine weitere erfindungsgemäße Ausführungsform zu erzielen, indem der Kompensationskondensator $C_K$ weggelassen wird und die Induktivitäten $L_K$ und $L_{g1}$ einstückig ausgeführt werden, insbesondere als Übertragerkopfwicklung selbst. Zusätzlich ist der Zweipol $Z_3$ als offene Verbindung ausgeführt. Bei diesem Ausführungsbeispiel ist dann nur die Kapazität $C_{g1}$ der Übertragerkopfwicklung nachgeschaltet. Es ist also die Anzahl der Bauelemente auf diese beiden reduzierbar und eine sehr kostengünstige Ausführungsform erreichbar.

Bei weiteren erfindungsgemäßen Ausführungsbeispielen ist durch besondere Wahl der Zweipole eine blindleistungskompensierte Ausführung des Übertragerkopfes ermöglicht. Es liegt also dann keine Spannung vor, wenn keine Leistung entnommen wird. Drei vorteilhafte Varianten sind dazu die im Folgenden genannten:

In erster Variante sind die Zweipole $Z_1$ und $Z_2$ als Kurzschlüsse ausgeführt, wobei der dritte Zweipol $Z_3$ als Induktivität $L_{g1}$ ausgeführt ist.

In zweiter Variante sind die Zweipole $Z_1$ und $Z_2$ als Kapazitäten mit dem jeweiligen Wert $2\,C_{g1}$ Ausgeführt, wobei der dritte Zweipol $Z_3$ als Unterbrechung ausgeführt ist.

In dritter Variante ist der Zweipol $Z_1$ als $C_{g1}$, der Zweipol $Z_2$ als Kurzschluss und der dritte Zweipol $Z_3$ als Unterbrechung ausgeführt.

## Patentansprüche

1. Vorrichtung zur berührungslosen Energieübertragung elektrischer Leistung aus einer oder mehreren Mittelfrequenzstromquellen, deren Frequenzen Abweichungen um die Mittelfrequenz $f_M$ aufweisen können, auf mindestens einen bewegten Verbraucher über eine oder mehrere Übertragungsstrecken und den Verbrauchern zugeordneten Übertragerköpfen mit nachgeschalteter Anpassschaltung zum Bereitstellen einer eingeprägten Mittelfrequenz-Spannung für den Verbraucher,

   wobei eine Übertragungsstrecke von einer Mittelfrequenzstromquelle mit einem eingeprägten Mittelfrequenzstrom gespeist wird,

   wobei die Anpassschaltung als stromgesteuerte Spannungsquelle ausgeführt ist,

   - wobei die Anpassschaltung als Vierpol V ausgesführt ist, der zumindest eine Kapazität ($C_{g1}$) mit einem Wert $C_{g1}$ und eine Induktivität ($L_{g1}$) mit einem Wert $L_{g1}$ umfasst,

   **dadurch gekennzeichnet, dass**
   zwischen eine erste Eingangsklemme der Anpassschaltung und die erste Eingangsklemme des inneren Vierpols ein erster Zweipol zwischengeschaltet ist und zwischen die zweite Eingangsklemme der Anpassschaltung und die zweite Eingangsklemme des inneren Vierpols ein zweiter Zweipol zwischengeschaltet ist und zwischen die beiden Ausgangsklemmen des inneren Vierpols ein dritter Zweipol geschaltet ist und

   die erste Ausgangsklemme des inneren Vierpols mit der ersten Ausgangsklemme der Anpassschaltung direkt verbunden ist und

   die zweite Ausgangsklemme des inneren Vierpols mit der zweiten Ausgangsklemme der Anpassschaltung direkt verbunden ist,
   wobei

- der dritte Zweipol als Induktivität mit dem Wert $L_{g1}$ der Induktivität ($L_{g1}$) ausgeführt ist
- oder die Summe der Induktivitäten des ersten und des zweiten Zweipol dem Wert $L_{g1}$ der Induktivität ($L_{g1}$) des inneren Vierpols gleicht und der dritte Zweipol eine Unterbrechung ist
- oder der erste und/oder der zweite Zweipol als Induktivität ausgeführt ist und der dritte Zweipol eine Unterbrechung ist.

2. Vorrichtung nach mindestens einem der vorangegangenen Ansprüche,
   **dadurch gekennzeichnet, dass**
   die Anpassschaltung als stromgesteuerte Spannungsquelle derart ausgeführt ist, dass der Betrag der Ausgangsspannung der Anpassschaltung dem Betrag des Eingangsstromes der Anpassschaltung proportional ist, insbesondere bei idealer Auslegung der Bauteile.

3. Vorrichtung nach mindestens einem der vorangegangenen Ansprüche,
   **dadurch gekennzeichnet, dass**
   dem Übertragerkopf sekundärseitig ein Kompensationskondensator parallel geschaltet ist

4. Vorrichtung nach mindestens einem der vorangegangenen Ansprüche,
   **dadurch gekennzeichnet, dass**
   die Kapazität des Kompensationskondensators mit der Induktivität $L_K$ der Sekundärseite des Übertragerkopfes einen Schwingkreis bildet, dessen Resonanzfrequenz mit der Mittelfrequenz $f_M$ übereinstimmt oder nicht mehr abweicht als 10%.

5. Vorrichtung nach mindestens einem der vorangegangenen Ansprüche,
   **dadurch gekennzeichnet, dass**
   der Übertragerkopf derart mit einem Kompensationskondensator ausgeführt ist, dass der Übertragerkopf auf seiner Ausgangsseite sich als eingeprägte Stromquelle verhält und/oder der Übertragerkopf zusammen mit seinem Kompensationskondensator $C_K$ eine Mittelfrequenzstromquelle darstellt, insbesondere mit einem möglichst großem Innenwiderstand.

6. Vorrichtung nach mindestens einem der vorangegangenen Ansprüche,
   **dadurch gekennzeichnet, dass**
   der Kompensationskondensator $C_K$ des Übertragerkopfes und die Induktivität $L_K$ des Übertragerkopfes derart dimensioniert sind, dass $f_1 = \dfrac{1}{2\pi\sqrt{L_K C_K}}$ von $f_o$ höchstens 10 % abweicht.

7. Vorrichtung nach mindestens einem der vorangegangenen Ansprüche,
   **dadurch gekennzeichnet, dass**
   der Kompensationskondensator $C_K$ des Übertragerkopfes und die Induktivität $L_K$ des Übertragerkopfes derart dimensioniert sind, dass $f_1 = \dfrac{1}{2\pi\sqrt{L_K C_K}}$ gleich ist zu $f_o$.

8. Vorrichtung nach mindestens einem der vorangegangenen Ansprüche,
   **dadurch gekennzeichnet, dass**
   die Anpassschaltung als derartiger Vierpol ausgeführt ist, dass
   bei ohmschem Verbraucher und konstanter Frequenz eines sinusförmigen Eingangsstroms der Betrag der Ausgangsspannung dem Betrag des Eingangsstroms mit dem Proportionalitätsfaktor Z proportional ist.

9. Vorrichtung nach Anspruch 8,
   **dadurch gekennzeichnet, dass**
   die Kapazität ($C_{g1}$) und die Induktivität ($L_{g1}$) den Proportionalitätsfaktor Z bestimmen.

10. Vorrichtung nach mindestens einem der vorangegangenen Ansprüche,
    **dadurch gekennzeichnet, dass**
    der Vierpol einen inneren Vierpol umfasst, welcher zwischen seinen Eingangsklemmen die Kapazität ($C_{g1}$) aufweist und die Induktivität ($L_{g1}$) zwischen einer ersten Eingangsklemme und einer ersten Ausgangsklemme geschaltet ist und die zweite Ausgangsklemme mit der zweiten Eingangsklemme direkt verbunden ist.

11. Vorrichtung nach mindestens einem der Ansprüche 1 bis 9,
    **dadurch gekennzeichnet, dass**
    der Vierpol einen inneren Vierpol umfasst, welcher zwischen seinen Eingangsklemmen die Induktivität ($L_{g1}$) aufweist und die Kapazität ($C_{g1}$) zwischen einer ersten Eingangsklemme und einer ersten Ausgangsklemme geschaltet ist und die zweite Ausgangsklemme mit der zweiten Eingangsklemme direkt verbunden ist.

12. Vorrichtung nach mindestens einem der vorangegangenen Ansprüche,
    **dadurch gekennzeichnet, dass**
    die Frequenz f des Eingangsstromes von der Frequenz $f_o = \dfrac{1}{2\pi\sqrt{L_{g1} C_{g1}}}$ höchstens 10 % abweicht.

**13.** Vorrichtung nach mindestens einem der vorangegangenen Ansprüche,
**dadurch gekennzeichnet, dass**
die Frequenz f des Eingangsstromes der Frequenz

$$f_o = \frac{1}{2\pi\sqrt{L_{g1}C_{g1}}}$$ gleich ist.

**14.** Vorrichtung nach mindestens einem der vorangegangenen Ansprüche 8 und 9,
**dadurch gekennzeichnet, dass**

der Proportionalitätsfaktor $Z = \sqrt{\dfrac{L_g}{C_{g1}}}$ beträgt.

**15.** Vorrichtung nach mindestens einem der vorangegangenen Ansprüche,
**dadurch gekennzeichnet, dass**
der erste und/oder der zweite Zweipol als direkte Verbindung, also Kurzschluss, ausgeführt ist.

**16.** Vorrichtung nach mindestens einem der vorangegangenen Ansprüche,
**dadurch gekennzeichnet, dass**
der dritte Zweipol als Unterbrechung ausgeführt ist, also nicht vorhanden ist.

**17.** Vorrichtung nach mindestens einem der vorangegangenen Ansprüche,
**dadurch gekennzeichnet, dass**
der erste und zweite Zweipol als Kapazität $2\,C_{g1}$ ausgeführt sind.

**18.** Vorrichtung nach mindestens einem der vorangegangenen Ansprüche,
**dadurch gekennzeichnet, dass**
der erste Zweipol als Kapazität $C_{g1}$ und der zweite Zweipol als Kurzschluss ausgeführt sind.

**19.** Vorrichtung nach mindestens einem der vorangegangenen Ansprüche,
**dadurch gekennzeichnet, dass**
der erste und zweite Zweipol jeweils als direkte Verbindung ausgeführt ist und der dritte Zweipol ein Kondensator mit der Kapazität $C_{g2}$ ist.

**20.** Vorrichtung nach mindestens einem der vorangegangenen Ansprüche,
**dadurch gekennzeichnet, dass**
die Kapazität $C_{g2}$ übereinstimmt mit der Kapazität $C_{g1}$ des inneren Vierpols.

**21.** Vorrichtung nach mindestens einem der vorangegangenen Ansprüche,
**dadurch gekennzeichnet, dass**
am Ausgang der Anpassschaltung ein Gleichrichter zum Erzeugen einer unipolaren Zwischenkreisspannung für einen vom Verbraucher umfassten Umrichter vorgesehen ist.

**Claims**

**1.** Device for contactless energy transmission of electric power from one or more medium-frequency current sources, whose frequencies may have deviations around the medium frequency $f_M$, to at least one moving load via one or more transmission lines and pick-ups, assigned to the loads,
having a downstream matching circuit for providing an impressed medium-frequency voltage for the load,
wherein a transmission line is fed with an impressed medium-frequency current from a medium-frequency current source,
wherein the matching circuit is formed as a current-controlled voltage source,

- wherein the matching circuit is formed as a four-terminal network V, which comprises at least one capacitance ($C_{g1}$) with a value $C_{g1}$ and one inductance ($L_{g1}$) with a value $L_{g1}$,

**characterised in that**
a first two-terminal network is inserted between a first input terminal of the matching circuit and the first input terminal of the inner four-terminal network, and a second two-terminal network is inserted between the second input terminal of the matching circuit and the second input terminal of the inner four-terminal network, and a third two-terminal network is connected between the two output terminals of the inner four-terminal network, and
the first output terminal of the inner four-terminal network is directly connected to the first output terminal of the matching circuit, and
the second output terminal of the inner four-terminal network is directly connected to the second output terminal of the matching circuit,
wherein

- the third two-terminal network is formed as an inductance with the value $L_{g1}$ of the inductance ($L_{g1}$)
- or the sum of the inductances of the first and of the second two-terminal network equals the value $L_{g1}$ of the inductance ($L_{g1}$) of the inner four-terminal network, and the third two-terminal network is a disconnection
- or the first and/or the second two-terminal network is formed as an inductance and the third two-terminal network is a disconnection.

**2.** Device according to at least one of the preceding claims,
**characterised in that**
the matching circuit is formed as a current-controlled voltage source in such a manner that the magnitude of the output voltage of the matching circuit is proportional to the magnitude of the input current of the matching circuit, in particular when the components have an ideal design.

3. Device according to at least one of the preceding claims,
**characterised in that**
a compensating capacitor is connected in parallel with the pick-up on the secondary side.

4. Device according to at least one of the preceding claims,
**characterised in that**
the capacitance of the compensating capacitor constitutes, with the inductance $L_K$ of the secondary side of the pick-up, a resonant circuit whose resonant frequency corresponds to the medium frequency $f_M$ or does not deviate by more than 10%.

5. Device according to at least one of the preceding claims,
**characterised in that**
the pick-up is formed with a compensating capacitor in such a manner that the pick-up behaves on its output side as an impressed current source and/or the pick-up constitutes, together with its compensating capacitor $C_K$, a medium-frequency current source, in particular with an internal resistance as large as possible.

6. Device according to at least one of the preceding claims,
**characterised in that**
the compensating capacitor $C_K$ of the pick-up and the inductance $L_K$ of the pick-up are dimensioned in such a manner that $f_1 = \dfrac{1}{2\pi\sqrt{L_K C_K}}$ deviates from $f_0$ by at most 10%.

7. Device according to at least one of the preceding claims,
**characterised in that**
the compensating capacitor $C_K$ of the pick-up and the inductance $L_K$ of the pick-up are dimensioned in such a manner that $f_1 = \dfrac{1}{2\pi\sqrt{L_K C_K}}$ is equal to $f_0$.

8. Device according to at least one of the preceding claims,
**characterised in that**
the matching circuit is formed as a four-terminal network such that, with a resistive load and constant frequency of a sinusoidal input current, the magnitude of the output voltage is proportional to the magnitude of the input current with the proportionality factor Z.

9. Device according to Claim 8,
**characterised in that**
the capacitance ($C_{g1}$) and the inductance ($L_{g1}$) determine the proportionality factor Z.

10. Device according to at least one of the preceding claims,
**characterised in that**
the four-terminal network comprises an inner four-terminal network which has the capacitance ($C_{g1}$) between its input terminals, and the inductance ($L_{g1}$) is connected between a first input terminal and a first output terminal, and the second output terminal is directly connected to the second input terminal.

11. Device according to at least one Claims 1 to 9,
**characterised in that**
the four-terminal network comprises an inner four-terminal network which has the inductance ($L_{g1}$) between its input terminals, and the capacitance ($C_{g1}$) is connected between a first input terminal and a first output terminal, and the second output terminal is directly connected to the second input terminal.

12. Device according to at least one of the preceding claims,
**characterised in that**
the frequency f of the input current deviates from the frequency $f_0 = \dfrac{1}{2\pi\sqrt{L_{g1} C_{g1}}}$ by at most 10%.

13. Device according to at least one of the preceding claims,
**characterised in that**
the frequency f of the input current is equal to the frequency $f_0 = \dfrac{1}{2\pi\sqrt{L_{g1} C_{g1}}}$ .

14. Device according to at least one of the preceding Claims 8 and 9,
**characterised in that**

the proportionality factor $Z = \sqrt{\dfrac{L_g}{C_{g1}}}$.

**15.** Device according to at least one of the preceding claims,
**characterised in that**
the first and/or the second two-terminal network is formed as a direct connection, that is to say a short circuit.

**16.** Device according to at least one of the preceding claims,
**characterised in that**
the third two-terminal network is formed as a disconnection, that is to say is not present.

**17.** Device according to at least one of the preceding claims,
**characterised in that**
the first and second two-terminal networks are formed as a capacitance 2 $C_{g1}$.

**18.** Device according to at least one of the preceding claims,
**characterised in that**
the first two-terminal network is formed as a capacitance $C_{g1}$ and the second two-terminal network is formed as a short circuit.

**19.** Device according to at least one of the preceding claims,
**characterised in that**
the first and second two-terminal networks are formed in each case as a direct connection and the third two-terminal network is a capacitor with the capacitance $C_{g2}$.

**20.** Device according to at least one of the preceding claims,
**characterised in that**
the capacitance $C_{g2}$ corresponds to the capacitance $C_{g1}$ of the inner four-terminal network.

**21.** Device according to at least one of the preceding claims,
**characterised in that**
there is provided at the output of the matching circuit a rectifier for generating a unipolar.intermediate-circuit voltage for a converter which the load comprises.

**Revendications**

**1.** Dispositif de transmission sans contact de puissance électrique à partir d'une ou plusieurs sources de courant à moyenne fréquence, dont les fréquences peuvent présenter des variations autour de la fréquence moyenne $f_M$, à au moins un consommateur mobile via un ou plusieurs trajets de transmission et des têtes émettrices associées aux consommateurs avec un circuit d'adaptation placé en aval pour mettre à disposition une tension à moyenne fréquence imposée au consommateur,
un trajet de transmission étant alimenté par une source de courant à moyenne fréquence avec un courant à moyenne fréquence imposé,
le circuit d'adaptation étant réalisé sous la forme d'une source de tension commandée en courant,
le circuit d'adaptation étant réalisé sous la forme d'un quadripôle V qui comprend au moins une capacité ($C_{g1}$) d'une valeur $C_{g1}$ et une inductance ($L_{g1}$) d'une valeur $L_{g1}$,
**caractérisé en ce que**
un premier dipôle est intercalé entre une première borne d'entrée du circuit d'adaptation et la première borne d'entrée du quadripôle interne et un deuxième dipôle est intercalé entre la deuxième borne d'entrée du circuit d'adaptation et la deuxième borne d'entrée du quadripôle interne et
un troisième dipôle est branché entre les deux bornes de sortie du quadripôle interne et
la première borne de sortie du quadripôle interne est reliée directement à la première borne de sortie du circuit d'adaptation et
la deuxième borne de sortie du quadripôle interne est reliée directement à la deuxième borne de sortie du circuit d'adaptation,

- le troisième dipôle étant réalisé sous la forme d'une inductance ayant la valeur $L_{g1}$ de l'inductance ($L_{g1}$)
- ou la somme des inductances du premier et du deuxième dipôle étant égale à la valeur $L_{g1}$ de l'inductance ($L_{g1}$) du quadripôle interne et le troisième dipôle étant une coupure
- ou le premier et/ou le deuxième dipôle étant réalisé(s) sous la forme d'une inductance et le troisième dipôle étant une coupure.

**2.** Dispositif selon au moins une des revendications précédentes,
**caractérisé en ce que**
le circuit d'adaptation est réalisé sous la forme d'une source de tension commandée en courant de façon que la valeur de la tension de sortie du circuit d'adaptation soit proportionnelle à la valeur du courant d'entrée du circuit d'adaptation, en particulier en cas de dimensionnement idéal des composants.

**3.** Dispositif selon au moins une des revendications précédentes,
**caractérisé en ce que**
un condensateur de compensation est branché en parallèle sur la tête émettrice côté secondaire.

**4.** Dispositif selon au moins une des revendications précédentes,
**caractérisé en ce que**
la capacité du condensateur de compensation forme avec l'inductance $L_K$ du côté secondaire de la tête émettrice un circuit oscillant dont la fréquence de résonance coïncide avec la fréquence moyenne $f_M$ ou n'en diffère pas de plus de 10 %.

**5.** Dispositif selon au moins une des revendications précédentes,
**caractérisé en ce que**
la tête émettrice est réalisée avec un condensateur de compensation de façon que la tête émettrice se comporte comme une source de courant imposé de son côté sortie et/ou que la tête émettrice forme avec son condensateur de compensation $C_K$ une source courant à moyenne fréquence, en particulier avec une résistance interne aussi grande que possible.

**6.** Dispositif selon au moins une des revendications précédentes,
**caractérisé en ce que**
le condensateur de compensation $C_K$ de la tête émettrice et l'inductance $L_K$ de la tête émettrice sont dimensionnés de façon que $f_1 = \dfrac{1}{2\pi\sqrt{L_K C_K}}$

diffère de $f_0$ au maximum de 10%.

**7.** Dispositif selon au moins une des revendications précédentes,
**caractérisé en ce que**
le condensateur de compensation $C_K$ de la tête émettrice et l'inductance $L_K$ de la tête émettrice sont dimensionnés de façon que $f_1 = \dfrac{1}{2\pi\sqrt{L_K C_K}}$ soit

égale à $f_0$.

**8.** Dispositif selon au moins une des revendications précédentes,
**caractérisé en ce que**
le circuit d'adaptation est réalisé sous la forme d'un quadripôle de façon qu'avec un consommateur ohmique et à fréquence constante d'un courant d'entrée sinusoïdal, la valeur de la tension de sortie soit proportionnelle à la valeur du courant d'entrée avec le facteur de proportionnalité Z.

**9.** Dispositif selon la revendication 8,
**caractérisé en ce que**
la capacité ($C_{g1}$) et l'inductance ($L_{g1}$) déterminent le facteur de proportionnalité Z.

**10.** Dispositif selon au moins une des revendications précédentes,
**caractérisé en ce que**
le quadripôle comprend un quadripôle, interne qui présente la capacité ($C_{g1}$) entre ses bornes d'entrées et l'inductance ($L_{g1}$) est branchée entre une première borne d'entrée et une première borne de sortie et la deuxième borne de sortie est reliée directement à la deuxième borne d'entrée.

**11.** Dispositif selon au moins une des revendications 1 à 9,
**caractérisé en ce que**
le quadripôle comprend un quadripôle interne qui présente l'inductance ($L_{g1}$) entre ses bornes d'entrées et la capacité ($C_{g1}$) est branchée entre une première borne d'entrée et une première borne de sortie et la deuxième borne de sortie est reliée directement à la deuxième borne d'entrée.

**12.** Dispositif selon au moins une des revendications précédentes,
**caractérisé en ce que**
la fréquence f du courant d'entrée diffère au maximum de 10 % de la fréquence

$$f_0 = \frac{1}{2\pi\sqrt{L_{g1} C_{g1}}} \; .$$

**13.** Dispositif selon au moins une des revendications précédentes,
**caractérisé en ce que**
la fréquence f du courant d'entrée est égale à la fréquence $f_0 = \dfrac{1}{2\pi\sqrt{L_{g1} C_{g1}}} \; .$

**14.** Dispositif selon au moins une des revendications précédentes 8 et 9,
**caractérisé en ce que**

le facteur de proportionnalité $Z = \sqrt{\dfrac{L_g}{C_{g1}}} \; .$

**15.** Dispositif selon au moins une des revendications précédentes,
**caractérisé en ce que**
le premier et/ou le deuxième dipôle est/sont réalisé (s) sous la forme d'une liaison directe, c'est-à-dire d'un court-circuit.

**16.** Dispositif selon au moins une des revendications précédentes,

**caractérisé en ce que**
le troisième dipôle est réalisé sous la forme d'une coupure, c'est-à-dire n'est pas présent.

17. Dispositif selon au moins une des revendications précédentes,
**caractérisé en ce que**
le premier et le deuxième dipôle sont réalisés sous la forme d'une capacité 2 $C_{g1}$.

18. Dispositif selon au moins une des revendications précédentes,
**caractérisé en ce que**
le premier dipôle est réalisé sous la forme d'une capacité $C_{g1}$ et le deuxième dipôle sous la forme d'un court-circuit.

19. Dispositif selon au moins une des revendications précédentes,
**caractérisé en ce que**
le premier et le deuxième dipôle sont réalisés chacun sous la forme d'une liaison directe et le troisième dipôle est un condensateur de capacité $C_{g2}$.

20. Dispositif selon au moins une des revendications précédentes,
**caractérisé en ce que**
la capacité $C_{g2}$ coïncide avec la capacité $C_{g1}$ du quadripôle interne.

21. Dispositif selon au moins une des revendications précédentes,
**caractérisé en ce que**
un redresseur permettant de générer une tension de circuit intermédiaire unipolaire pour un variateur de vitesse compris par le consommateur est prévu à la sortie du circuit d'adaptation.

Fig. 1

Fig. 2

Fig. 3

EP 1 661 244 B1

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 10053373 A1
- JP 8308150 A
- US 6252386 B1
- DE 10053373 A
- JP 8308151 A